# EUROPÄISCHE PATENTSCHRIFT

(11) **EP 3 715 863 B1**
(45) Veröffentlichungstag und Bekanntmachung des Hinweises auf die Patenterteilung: **30.10.2024**
(21) Anmeldenummer: 20166247.5
(22) Anmeldetag: 27.03.2020
(51) Int. Cl.: G01R 1/04, G01R 31/28

(54) **TESTVORRICHTUNG ZUM TESTEN ELEKTRISCHER BAUTEILE, VERWENDUNG DER TESTVORRICHTUNG ZUM TESTEN EINES ELEKTRISCHEN BAUTEILS UND VERFAHREN ZUM TESTEN ELEKTRISCHER BAUTEILE MITTELS DER TESTVORRICHTUNG**
TEST DEVICE FOR TESTING ELECTRICAL COMPONENTS, USE OF THE TEST DEVICE FOR TESTING AN ELECTRICAL COMPONENT AND METHOD FOR TESTING ELECTRICAL COMPONENTS USING THE TEST DEVICE
DISPOSITIF DESTINÉ AUX ESSAIS DES COMPOSANTS ÉLECTRIQUES, UTILISATION DU DISPOSITIF D'ESSAI POUR FAIRE DES ESSAIS SUR UN COMPOSANT ÉLECTRIQUE ET PROCÉDÉ D'ESSAI DES COMPOSANTS ÉLECTRIQUES AU MOYEN DU DISPOSITIF D'ESSAI

(30) Priorität: 28.03.2019 DE 102019002266
(43) Veröffentlichungstag der Anmeldung: 30.09.2020
(73) Patentinhaber: Yamaichi Electronics Deutschland GmbH, 85609 Aschheim-Dornach (DE)
(72) Erfinder: BTAHRI, Jemei, 4000 Sousse (TN); QUITER, Michael, 57482 Wenden (DE); SERNA, Yoann, 6511 Zams (AT)
(74) Vertreter: Müller-Boré & Partner Patentanwälte PartG mbB

(56) Entgegenhaltungen:
- DE-A1- 10 037 448
- US-A- 5 153 504
- US-A- 5 557 211
- US-B1- 6 496 001

## Beschreibung

Die Erfindung betrifft eine Testvorrichtung zum Testen elektrischer Bauteile, eine Verwendung der Testvorrichtung zum Testen eines elektrischen Bauteils und ein Verfahren zum Testen elektrischer Bauteile mittels der Testvorrichtung.

Herkömmliche Testvorrichtungen zum Testen elektrischer Bauteile weisen in der Regel eine Bauteilaufnahmeeinheit auf, in die das zu testende elektrische Bauteil, beispielsweise ein Printed-Circuit-Board (PCB) oder ein Mikrochip, eingesetzt wird. Die Bauteilaufnahmeeinheit weist in der Regel Kontaktierungsmittel auf, welche dazu ausgelegt sind das in der Bauteilaufnahmeeinheit eingesetzte elektrische Bauteil mit der Testvorrichtung elektrisch zu verbinden. Um eine sichere elektrische Verbindung des elektrischen Bauteils mit der Bauteilaufnahmeeinheit zu gewährleisten, weist die Bauteilaufnahmeeinheit bzw. Testvorrichtung üblicherweise ein Sicherungselement auf, mit dem das Bauteil in der Bauteilaufnahmeeinheit gesichert bzw. fixiert wird, so dass ein elektrischer Kontakt zwischen dem Kontaktierungsmittel der Bauteilaufnahmeeinheit und bauteilseitigen Kontaktelementen sicher gewährleistet ist. Ferner kann die Testvorrichtung zum Durchführen eines Bauteiltests mit einer Prüfvorrichtung verbunden werden, um das in der Bauteilaufnahmeeinheit aufgenommene Bauteil einer Testprozedur zu unterziehen.

Das Sichern des in der Bauteilaufnahmeeinheit angeordneten zu testenden Bauteils mittels des Sicherungselements kann allerdings zu Beschädigungen an dem Bauteil führen, beispielsweise einer Beschädigung der bauteilseitigen Kontaktelemente. Des Weiteren sind der Wechsel bzw. Austausch des zu testenden Bauteils aufwendig. Zuerst muss das Sicherungselement gelöst werden, um im Anschluss das Bauteil aus der Bauteilaufnahmeeinheit zu entnehmen. Anschließend ist ein anderes zu testendes Bauteil in der Bauteilaufnahmeeinheit einzulegen, welches durch entsprechendes Betätigen des Sicherungselements in der Bauteilaufnahmeeinheit gesichert werden muss.

Ferner betrifft die DE 100 37 448 A1 eine Vorrichtung zum Prüfen und/oder Bearbeiten kleiner elektrischer oder elektronischer Bauteile, die einen Bauteilkörper und wenigstens zwei sich seitlich von diesem erstreckende, flache elektrische Bauteilkontaktelemente mit einer ersten Flachseite und einer gegenüberliegenden zweiten Flachseite aufweisen, mit Kontaktmitteln zum galvanischen Kontaktieren der Bauteilkontaktelemente mit jeweils wenigstens einem ersten Arbeitskontaktelement und einem zweiten Arbeitskontaktelement auf wenigstens einer Flachseite der Bauteilkontaktelemente sowie einer verfahrbaren Greifeinrichtung um Positionieren wenigstens eines Bauteils in einer Prüf- bzw. Bearbeitungsposition, in der die Arbeitskontaktelemente die Bauteilkontaktelemente galvanisch kontaktieren, wobei die Greifeinrichtung und die Kontaktmittel derart ausgebildet und angeordnet sind, dass das jeweilige Bauteilkontaktelement mit dem ersten Arbeitskontaktelement auf seiner ersten Flachseite und dem zweiten Arbeitskontaktelement auf seiner zweiten Flachseite kontaktiert wird.

Die US 5 153 504 A betrifft eine Leiterplattenprüfvorrichtung, die einen stationären Rahmen, der beweglich an einer Sondenplatte befestigt ist, die starr auf der Sondenoberfläche der Prüfvorrichtung angeordnet ist, umfasst. Der stationäre Rahmen umfasst darin Kolbenkammern und Mittel zum Bereitstellen von unter Druck stehendem Fluid für die Kammer und zum Ablassen des Fluids aus der Kammer. Die in den Kammern angeordneten Kolben haben ein Ende, das vom stationären Rahmen nach unten vorsteht und starr am beweglichen Rahmen befestigt ist. Der bewegliche Rahmen ist so bemessen, dass er den Umfang der zu prüfenden Leiterplatte berührt. Wenn also eine Leiterplatte auf die Sondenplatte gelegt wird, wird der stationäre Rahmen so bewegt, dass der bewegliche Rahmen in einem Stoßverhältnis zum Umfang der Leiterplatte steht. Der stationäre Rahmen wird dann eingerastet, um eine weitere Bewegung zu verhindern. Den Kolbenkammern des stationären Rahmens wird dann unter Druck stehendes Fluid zugeführt, wodurch die Kolben nach unten gedrückt werden. Die Bewegung der Kolben bewirkt dann, dass sich der bewegliche Rahmen nach unten bewegt, so dass die Leiterplatte fest und zuverlässig auf den Prüfspitzen sitzt und ein elektrischer Durchgang zwischen den elektronischen Komponenten auf der Leiterplatte und der Prüfausrüstung bereitgestellt wird.

Die US 6 496 001 B1 betrifft ein Verfahren und eine Vorrichtung zur Planarisierung. Das Planarisierungswerkzeug verfügt über eine Basis, die das Planarisierungswerkzeug unterstützt. An der Basis ist ein Stützscharnier zusammen mit Dämpfungspfosten und Ruhepfosten angebracht, die eine am Stützscharnier angelenkte Schwenkplatte tragen. Eine Druckanordnung ist durch Haltevorrichtungen an der Schwenkplatte angebracht. Die Druckbaugruppe lädt eine Vorrichtung unter der Testplatinenbaugruppe, die mit der Haltevorrichtung an der Druckbaugruppe montiert ist.

Die US 5 557 211 A betrifft eine Testvorrichtung zum Testen von Leiterplatten. Die Testvorrichtung weist eine Vakuumkammer zwischen einer stationären Sondenplatte und einer beweglichen oberen Platte auf. Separate einstellbare Linearlager in Quadranten der Vorrichtung sorgen für eine parallele Ausrichtung zwischen der oberen Platte und der Sondenplatte. Die Testvorrichtung umfasst Messfühler zum Kontakt mit den Testpunkten in den Schaltkreisen der Leiterplatte. Wenn ein Unterdruck in der Vakuumkammer erzeugt wird, wird der Unterdruck ebenfalls in dem Raum unterhalb der Leiterplatte und oberhalb der Kopfplatte aufgebracht. Dies drückt die Leiterplatte nach unten in Richtung der und in elektrischen Kontakt mit den Testmessfühlern zum Verwenden beim Durchführen eines Schaltkreisstromflußtests.

Es ist daher Aufgabe der vorliegenden Erfindung eine Testvorrichtung, welche Beschädigungen an zu testenden elektrischen Bauteilen durch das Anordnen des Bauteils in der Testvorrichtung vermeidet und einen einfachen Austausch des Bauteils ermöglicht, ein entsprechendes Testverfahren sowie eine Verwendung dieser Testvorrichtung, bereitzustellen.

Diese Aufgabe wird durch die Gegenstände der unabhängigen Ansprüche gelöst. Bevorzugte Ausführungsformen sind in den abhängigen Ansprüchen definiert.

Gemäß einem Aspekt der Erfindung wird eine Testvorrichtung zum Testen elektrischer Bauteile gemäß Anspruch 1 bereitgestellt.

Vorteilhafter Weise ermöglicht die mittels Unterdrucks bewegbare Bauteilhalteeinheit, dass ein elektrischer Kontakt zwischen dem Bauteil und den an dem Gehäuse angeordneten Kontaktierungsmittel hergestellt werden kann, ohne dass es eines Sicherungsmittels wie bei herkömmlichen Testvorrichtungen Bedarf. Mit anderen Worten, der elektrische Kontakt zwischen dem Bauteil und dem an dem Gehäuse vorgesehenen Kontaktierungsmittel wird lediglich durch Erzeugen des Unterdrucks in der Druckkammer gegenüber einem Druck in der Umgebung der Testvorrichtung hergestellt. Eine mechanisches Sicherungselement, welches das Bauteil an der Bauteilhalteeinheit sichert, ist nicht zwingend notwendig. Dadurch werden Beschädigungen des Bauteils, welche bei herkömmlichen Testvorrichtungen durch das Sicherungselement verursacht werden können, vermieden.

Ferner weist das Gehäuse einen Hohlraum auf, der als Druckkammer ausgebildet ist. Der Hohlraum ist über eine an dem Gehäuse angeordnete Öffnung zugänglich, durch welche die Bauteilhalteeinheit in das Gehäuse bzw. den Hohlraum einführbar ist. Die Bauteilhalteinheit ist in dem Hohlraum bewegbar angeordnet.

Der Hohlraum und die Bauteilhalteeinheit fungieren wie ein Zylinder mit entsprechenden Kolben. Der Hohlraum ist zylindrisch ausgebildet und erstreckt sich entlang einer Bewegungsrichtung, entlang welcher sich die Bauteilhalteeinheit bewegen kann. Beim Bewegen der Bauteilhalteinheit in Richtung der Bewegungsrichtung, wird die Bauteilhalteinheit weiter in das Gehäuse hinein bewegt. Beim Bewegen der Bauteilhalteinheit entgegen der Bewegungsrichtung, wird die Bauteilhalteinheit aus dem Gehäuse heraus bewegt.

Ferner weist die Bauteilhalteeinheit einen ersten Abschnitt auf, welcher zylindrisch ausgebildet ist und welcher zumindest abschnittsweise in dem Hohlraum bzw. der Druckkammer bewegbar angeordnet ist. Der erste Abschnitt liegt dabei zumindest teilweise flächig an der Innenseite des Hohlraums an, sodass eine ausreichende Luftdichtigkeit zwischen dem Gehäuse und der Bauteilhalteinheit bzw. dem ersten Abschnitt der Bauteilhalteinheit gewährleistet ist, so dass der in der Druckkammer erzeugte Unterdruck gehalten werden kann.

Beim Erzeugen eines Unterdrucks in der Druckkammer bewegt sich die Bauteilhalteeinheit in das Gehäuse hinein bzw. wird der erste Abschnitt der Bauteilhalteeinheit in den Hohlraum des Gehäuses entlang der Bewegungsrichtung hineingezogen.

Ferner weist die Bauteilhalteeinheit einen zweiten Abschnitt auf, welche an dem ersten Abschnitt der Bauteilhalteeinheit angeordnet ist. Dabei kann der zweite Abschnitt an einem der Bewegungsrichtung entgegenliegendem Ende des ersten Abschnitts angeordnet sein. Des Weiteren ist vorgesehen, dass das zu testende Bauteil auf dem zweiten Abschnitt der Bauteilhalteeinheit aufgelegt werden kann. Ferner kann die Bauteilhalteeinheit derart ausgebildet sein, dass der zweite Abschnitt in der Testposition nicht in dem Hohlraum angeordnet ist.

Vorzugsweise ist das Gehäuse massiv ausgebildet, so dass die Druckkammer bei Vorliegen eines Unterdrucks unterdruckbeständig ist und damit stabil bzw. formunveränderlich bleibt.

Des Weiteren kann die Testvorrichtung einen elektrischen Anschluss aufweisen, um die Testvorrichtung mit einer Prüfvorrichtung elektrisch zu verbinden. Ferner können die an dem Gehäuse angeordneten Kontaktierungsmittel derart ausgebildet sein, um eine elektrische Verbindung zwischen dem zu testenden Bauteil und dem elektrischen Anschluss herzustellen. Somit ist es möglich, mittels einer Prüfvorrichtung Eingabesignale in das zu testende Bauteil einzugeben, und daraufhin Ausgabesignale des Bauteils mit der Prüfvorrichtung zu empfangen. Die Ausgabesignale können mittels der Prüfvorrichtung mit Referenzsignalen abgeglichen werden, um zu bestimmen, ob das Bauteil fehlerfrei funktioniert.

Vorzugsweise ist die Bauteilhalteeinheit dazu ausgebildet ist, das aufgelegte Bauteil mittels des Unterdrucks zu halten. Insbesondere kann die Bauteilhalteeinheit dazu ausgebildet sein, dass das auf der Bauteilhalteeinheit aufgelegte Bauteil mit der Druckkammer in Verbindung steht.

Vorteilhafter Weise werden durch das Halten des Bauteils mittels des Unterdrucks keine weiteren Sicherungsmittel benötigt, um das Bauteil an der Bauteilhalteeinheit zu sichern. Ferner wird dadurch ermöglicht, dass eine ausreichende elektrische Kontaktierung zwischen dem Bauteil und dem an dem Gehäuse angeordneten Kontaktierungsmittel erreicht wird, wenn das Bauteil die an dem Gehäuse angeordneten Kontaktierungsmittel kontaktiert. Insbesondere werden bei Erzeugen des Unterdrucks in der Druckkammer, das Bauteil bzw. bauteilseitig vorgesehene Kontaktierungsmittel in Richtung der an dem Gehäuse angeordneten Kontaktierungsmittel (gehäuseseitige Kontaktierungsmittel) bewegt, um einen elektrischen Kontakt zu ermöglichen.

Vorzugsweise weist die Bauteilhalteeinheit eine Auflagefläche auf, auf die das zu testende Bauteil zumindest teilweise flächig aufgelegt wird. Beim Erzeugen eines Unterdrucks in der Druckkammer, kann das Bauteil somit auf der Bauteilhalteeinheit im Wesentlichen luftdicht aufliegen, sodass der Unterdruck in der Druckkammer erhalten bleibt.

Vorzugsweise weist die Auflagefläche eine Öffnung auf, die in Verbindung mit der Druckkammer steht. Insbesondere ist die Öffnung dazu ausgebildet, einen Fluidkanal zwischen einem auf der Bauteilhalteeinheit aufgelegten Bauteil und der Druckkammer herzustellen.

Vorteilhafter Weise steht das auf der Bauteilhalteeinheit aufgelegte Bauteil mittels der Öffnung in Verbindung mit der Druckkammer, so dass das Bauteil durch Erzeugen eines Unterdrucks in der Druckkammer auf der Bauteilhalteeinheit gehalten wird. Dadurch können weitere Sicherungselemente zum Sichern des Bauteils auf der Bauteilhalteeinheit vermieden werden.

Die Auflagefläche kann im Wesentlichen orthogonal zur Bewegungsrichtung der Bauteilhalteeinheit angeordnet sein, wobei die Öffnung mittig in der Auflagefläche angeordnet sein kann. Statt einer Öffnung können allerdings auch mehrere Öffnungen vorgesehen sein, mittels der ein Fluidkanal oder mehrere Fluidkanäle zwischen dem Bauteil und der Druckkammer ausgebildet ist oder sind.

Vorzugsweise ist ein innerer Bereich der Auflagefläche, welcher um die Öffnung herum angeordnet ist, gegenüber einem äußeren Bereich der Auflagefläche in Richtung der Bewegungsrichtung zurückgenommen, so das zwischen dem inneren Bereich und einem aufgelegten Bauteil ein Hohlraum ausgebildet ist. Vorzugsweise ermöglicht der zurückgenommene innere Bereich, dass eine größere Fläche des Bauteils dem Unterdruck ausgesetzt ist, wodurch sich der Unterdruck auf eine größere Fläche des Bauteils verteilt. Dadurch kann eine punktuelle Belastung des Bauteils durch den Unterdruck reduziert werden.

Vorzugsweise ist die Testvorrichtung dazu ausgebildet, dass beim Entfallen des Unterdrucks, die Bauteilhalteeinheit in eine Entlastungsposition bewegbar ist, bei der das zu testende Bauteil die an dem Gehäuse angeordneten Kontaktierungsmittel nicht kontaktiert.

Zum Einnehmen der Entlastungsposition, kann die Bauteilhalteeinheit entgegen der Bewegungsrichtung bewegt werden. Mit anderen Worten, zum Einnehmen der Entlastungsposition bewegt sich die Bauteilhalteeinheit zumindest abschnittsweise aus dem Gehäuse heraus, vorzugsweise nicht vollständig. Insbesondere kann vorgesehen sein, dass die Bauteilhalteeinheit federnd an dem Gehäuse gelagert ist, sodass beim Entfallen des Unterdrucks die Bauteilhalteeinheit aus dem Gehäuse bewegt wird. Beispielsweise können zwischen dem zweiten Abschnitt der Bauteilhalteeinheit und dem Gehäuse Federelemente ausgebildet sein, die beim Entfallen des Unterdrucks den zweiten Abschnitt der Bauteilhalteeinheit und somit die Bauteilhalteeinheit von dem Gehäuse wegdrücken.

Alternativ oder optional kann vorgesehen sein, dass die Bauteilhalteeinheit durch Erzeugen eines Überdrucks in der Druckkammer in die Entlastungsposition bewegbar ist.

Vorzugsweise weist die Testvorrichtung einen an dem Gehäuse angeordneten Druckanschluss zum Herstellen einer Verbindung zwischen der Druckkammer und einem Druckkontrollmittel auf, und/oder die Testvorrichtung selbst weist ein Druckkontrollmittel zum Erzeugen des Unterdrucks in der Druckkammer auf.

Insbesondere ist das Druckkontrollmittel dazu ausgebildet, einen definierten Druck in der Druckkammer zu erzeugen, beispielsweise einen definierten Unterdruck oder Überdruck in Bezug auf einen Druck in der Umgebung der Testvorrichtung. Als Druckkontrollmittel kann zum Beispiel eine Vakuumpumpe vorgesehen sein, die über den Druckanschluss mit der Testvorrichtung gekoppelt ist. Vorteilhafter Weise ermöglicht dies einen modularen Aufbau der Testvorrichtung und des Druckkontrollmittels, sodass bei einem Defekt das Druckkontrollmittel bzw. die Testvorrichtung schnell ausgetauscht werden kann.

Alternativ oder optional kann das Druckkontrollmittel auch in der Testvorrichtung integriert sein, womit eine kompakte Bauweise ermöglicht wird.

Vorzugsweise weist die Testvorrichtung einen elektrischen Anschluss zum Verbinden der Kontaktierungsmittel mit einer Prüfvorrichtung auf.

Vorzugsweise weist die Testvorrichtung ein Klemmmittel auf, das dazu ausgebildet ist, das zu testende Bauteil auf die Kontaktierungsmittel zu drücken.

Vorteilhafter Weise können durch das Klemmmittel auf das Bauteil einwirkende Biegemomente reduziert werden. Entsprechende Biegemomente können dadurch entstehen, dass durch Bewegen des Bauteils in Richtung der Bewegungsrichtung und Aufliegen des Bauteils auf den an dem Gehäuse angeordneten Kontaktierungsmittel mechanische Spannungen an dem Bauteil entstehen. Insbesondere bei Bauteilen, deren elektrische Kontaktierung, welche mit den gehäuseseitigen Kontaktierungsmitteln elektrisch verbunden wird, weit außen an dem Bauteil angeordnet ist, kann das Klemmmittel eine Reduktion der Biegemomente bewirken. Insbesondere sind die Klemmmittel dazu ausgebildet, mit einem Abschnitt des Klemmmittels auf das Bauteil zu drücken, welcher dem an dem Gehäuse angeordneten Kontaktmittel gegenüberliegend angeordnet ist.

Vorzugsweise kann das Klemmmittel als federgelagertes Klemmmittel ausgebildet sein. Insbesondere kann das Klemmmittel beweglich an dem Gehäuse ausgebildet sein und mittels eines Federelements in einer Klemmposition positionierbar sein, in der das Klemmmittel das Bauteil auf das an dem Gehäuse angeordnete Kontaktierungsmittel drückt. Ferner kann das Klemmmittel dazu ausgebildet sein, einfach zurückstellbar zu sein, d.h. aus der Klemmposition bewegbar zu sein, um diese zu lösen.

Vorzugsweise können die an dem Gehäuse angeordneten Kontaktierungsmittel als Federkontaktstifte ausgebildet sind.

Vorteilhafter Weise ermöglichen die Federkontaktstifte eine einfache und rückstandslos lösbare elektrische Verbindung zwischen der Testvorrichtung und dem zu testenden Bauteil. Insbesondere erstrecken sich die Federkontaktstifte entlang der Bewegungsrichtung.

Vorzugsweise ist die Bauteilhalteeinheit dazu ausgebildet, das aufgelegte Bauteil mittels des Unterdrucks zu halten, wobei keine Sicherungsmittel vorgesehen sind, die das Bauteil an der Bauteilhalteeinheit sichern.

Gemäß einem weiteren Aspekt der Erfindung wird eine Verwendung einer zuvor beschriebenen Testvorrichtung zum Testen eines elektrischen Bauteils bereitgestellt.

Gemäß einem weiteren Aspekt der Erfindung wird ein Verfahren zum Testen eines elektrischen Bauteils mittels der zuvor beschriebenen Testvorrichtung bereitgestellt, aufweisend: Auflegen eines zu testenden Bauteils auf die Bauteilhalteeinheit, Erzeugen eines Unterdrucks in der Druckkammer und Testen des Bauteils.

Die vorgeschlagene Verwendung der Testvorrichtung sowie das Verfahren zum Testen eines elektrischen Bauteils können gemäß den obenstehenden Ausführungen fortgebildet werden.

Im Folgenden wird eine Ausführungsform der Erfindung anhand der beiliegenden Figuren näher beschrieben. Es versteht sich, dass die vorliegende Erfindung nicht auf diese Ausführungsform beschränkt ist, und dass einzelne Merkmale der Ausführungsform im Rahmen der beiliegenden Ansprüche zu weiteren Ausführungsformen kombiniert werden können.

Es zeigen:
- **Fig. 1**: eine perspektivische Ansicht einer Testvorrichtung;
- **Fig. 2**: eine perspektivische Ansicht der Testvorrichtung mit einem zu testenden Bauteil in einer Testposition;
- **Fig. 3**: eine Querschnittsansicht der Testvorrichtung; und
- **Fig. 4**: eine weitere Querschnittsansicht der Testvorrichtung.

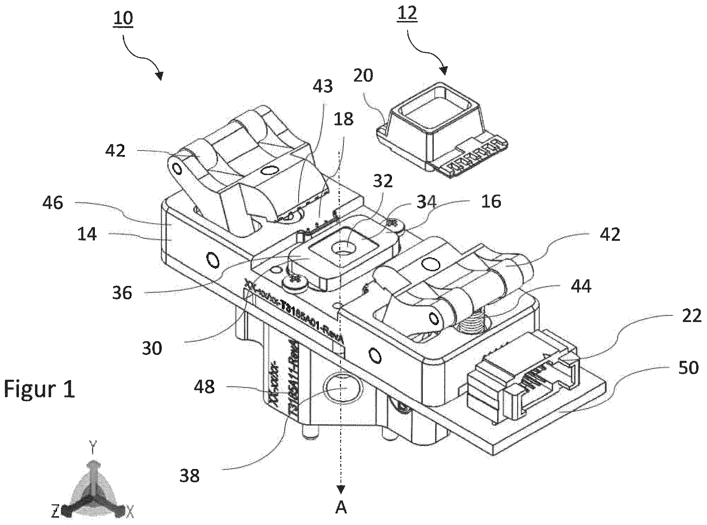

Fig. 1 zeigt eine Testvorrichtung 10 zum Testen eines elektrischen Bauteils 12. Die Testvorrichtung 10 weist ein Gehäuse 14 auf, in welchem eine Bauteilhalteeinheit 16 beweglich angeordnet ist. Die Bauteilhalteeinheit 16 ist dazu ausgelegt, sich entlang der gezeigten Bewegungsrichtung A zu bewegen. Ferner ist die Bauteilhalteeinheit 16 dazu ausgelegt, dass zu testende Bauteil 12 durch Auflegen des Bauteils 12 auf eine Auflagefläche 30 der Bauteilhalteinheit 16 zu halten.

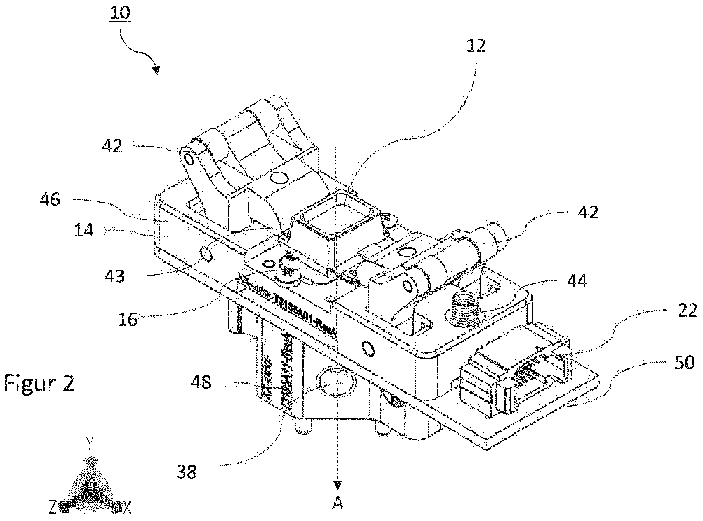

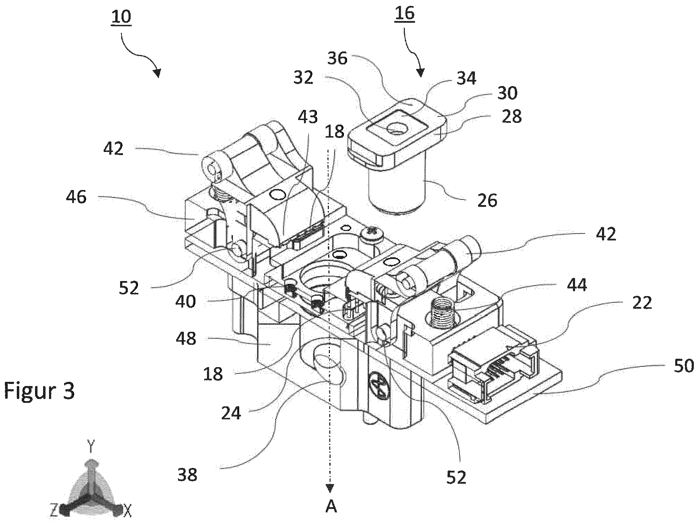

In dem Gehäuse 14 ist ferner eine Druckkammer 24 angeordnet (siehe Fig. 3), welche in Kontakt mit der Bauteilhalteeinheit 16 steht. Beim Erzeugen eines Unterdrucks in der Druckkammer 24 wird die Bauteilhalteeinheit 16 entlang der Bewegungsrichtung A zumindest teilweise in das Gehäuse 14 hinein bewegt (siehe Fig. 2). Durch das Bewegen der Bauteilhalteeinheit 16 in Richtung der Bewegungsrichtung A kontaktiert das Bauteil 12 an dem Gehäuse 14 angeordnete Kontaktierungsmittel 18, welche im Rahmen der vorliegenden Offenbarung auch als gehäuseseitige Kontaktierungsmittel 18 bezeichnet werden. Insbesondere erfolgt durch das Erzeugen eines Unterdrucks in der Druckkammer 24 eine elektrische Kontaktierung der gehäuseseitigen Kontaktierungsmittel 18 mit elektrischen Kontaktierungsmitteln 20 des Bauteils 12, welche im Rahmen der vorliegenden Offenbarung auch als bauteilseitige Kontaktierungsmittel 20 bezeichnet werden.

Somit wird durch das Erzeugen eines Unterdrucks in der Druckkammer 24 gegenüber einem Druck in der Umgebung der Testvorrichtung 10, die Bauteilhalteeinheit 16 in eine Testposition bewegt, bei der das Bauteil 12 die gehäuseseitigen Kontaktierungsmittel 18 elektrisch kontaktiert. Mittels eines an der Testvorrichtung 10 vorgesehenen elektrischen Anschlusses 22 kann die Testvorrichtung 10 mit einer nicht gezeigten Prüfvorrichtung verbunden werden. Die Prüfvorrichtung ist mittels des elektrischen Anschlusses 22 in der oben beschriebenen Testposition elektrisch mit dem Bauteil 12 verbunden, sodass das Bauteil 12 einem Funktionstest unterzogen werden kann.

Ferner weist das Gehäuse 14 einen Druckanschluss 38 auf, der in Kontakt mit der Druckkammer 24 steht. Mittels des Druckanschlusses 38, kann ein Druckkontrollmittel (nicht gezeigt) mit der Druckkammer 24 verbunden werden, um innerhalb der Druckkammer 24 einen definierten Druck, beispielsweise einen Unterdruck oder Überdruck gegenüber einem Druck in der Umgebung der Testvorrichtung 10, zu erzeugen.

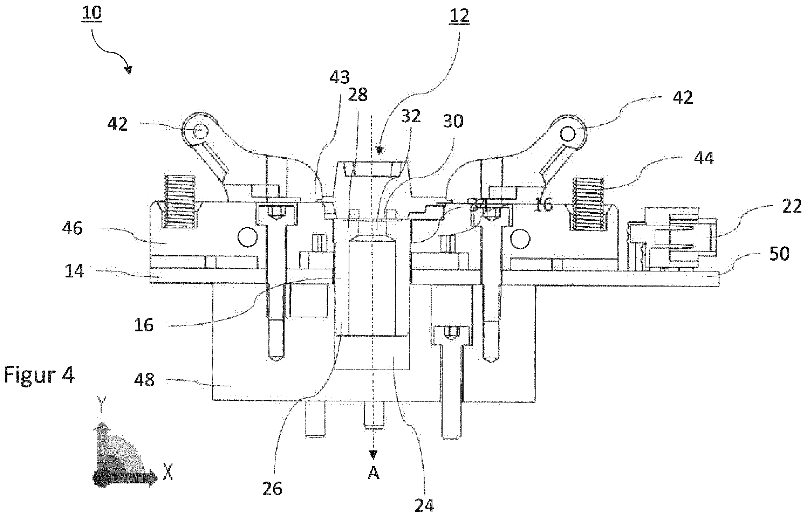

Mit Bezugnahme auf die Fig. 3 und 4 wird im Folgenden der Aufbau der Druckkammer 24 und der Aufbau der Bauteilhalteeinheit 16 näher beschrieben. Wie in den Fig. 3 und 4 gezeigt, weist das Gehäuse 14 einen im Wesentlichen zylindrisch ausgebildeten Hohlraum auf, welcher als Druckkammer 24 fungiert. Dieser Hohlraum 24 erstreckt sich im Wesentlichen entlang der Bewegungsrichtung A. Des Weiteren besteht die Bauteilhalteeinheit 16 aus einem ersten Abschnitt 26, welcher ebenfalls zylindrisch ausgebildet ist. Der erste Abschnitt 26 ist dazu ausgelegt, zumindest abschnittsweise in dem Hohlraum bzw. der Druckkammer 24 angeordnet zu sein und gegenüber dem Gehäuse 14 beweglich zu sein, wodurch eine Bewegung der Bauteilhalteeinheit 16 entlang der Bewegungsrichtung A gewährleistet ist. Ferner steht der erste Abschnitt 26 der Bauteilhalteeinheit 16 in Kontakt mit der Druckkammer 24, sodass ein in der Druckkammer 24 anliegender Unterdruck oder Überdruck auf den ersten Abschnitt 26 der Bauteilhalteeinheit 16 wirkt. D.h., beim Erzeugen eines Unterdrucks in der Druckkammer 24 wird der erste Abschnitt 26 der Bauteilhalteeinheit 16 zumindest abschnittsweise in das Gehäuse 14 hinein bewegt. Ferner liegt der erste Abschnitt 26 der Bauteilhalteeinheit 16 zumindest abschnittsweise flächig an der zylindrischen Innenoberfläche des Hohlraums 24 des Gehäuses 14 an. Damit kann der erste Abschnitt 26 im Wesentlichen luftdicht in dem Gehäuse 14 bzw. der Druckkammer 24 angeordnet sein, sodass ein in der Druckkammer 24 anliegender Unterdruck aufrechterhalten bleibt und ein Druckausgleich mit der Umgebungsluft im Wesentlichen verhindert wird.

Wie in den Fig. 3 und 4 gezeigt, weist die Bauteilhalteeinheit 16 einen zweiten Abschnitt 28 auf, welcher an einem der Bewegungsrichtung A entgegenliegendem Ende des ersten Abschnitts 26 der Bauteilhalteeinheit 16 angeordnet ist. Der zweite Abschnitt 28 der Bauteilhalteeinheit weist gegenüber dem ersten Abschnitt 26 der Bauteilhalteeinheit 16 einen quer zur Bewegungsrichtung A liegenden größeren Querschnitt auf, so dass der zweite Abschnitt 28 nicht in die Druckkammer 24 einführbar ist.

Des Weiteren weist der zweite Abschnitt 28 die Auflagefläche 30 auf, auf die das zu testende Bauteil 12 aufgelegt wird und welche sich quer zur Bewegungsrichtung A erstreckt. Im Inneren der Auflagefläche 30 bzw. Zentrum der Auflagefläche 30 ist eine Öffnung 32 vorgesehen, mit der ein Fluidkanal bereitgestellt wird, der eine Verbindung zur Druckkammer 24 ermöglicht. Insbesondere steht durch die Öffnung 32 das auf der Bauteilhalteeinheit 16 aufgelegte Bauteil 12 mit der Druckkammer 24 in Verbindung, sodass bei einem vorhandenen Unterdruck in der Druckkammer 24 das Bauteil 12 durch den Unterdruck auf der Auflagefläche 30 gehalten wird.

Ferner weist die Auflagefläche 30 einen inneren Bereich 34 auf, der um die Öffnung 32 herum angeordnet ist und der gegenüber einem äußeren Bereich 36 der Auflagefläche 30 in Bewegungsrichtung A zurückgenommen ist. Wie in Fig. 4 gezeigt liegt somit das Bauteil 12 lediglich auf dem äußeren Bereich 36 der Auflagefläche 30 flächig auf, wodurch der Unterdruck, welcher das Bauteil 12 auf der Bauteilhalteeinheit 16 hält, an einer größeren Fläche des Bauteils 12 angreifen kann. Somit wird auf vorteilhafte Weise die durch den Unterdruck erzeugte Belastung an dem Bauteil 12 reduziert.

Ferner wird durch das flächige Aufliegen des Bauteils 12 auf dem äußeren Bereich 36 gewährleistet, dass das Bauteil 12 im Wesentlichen luftdicht auf der Bauteilhalteeinheit 16 aufliegt, so dass der Unterdruck in der Druckkammer 24 aufrechterhalten werden kann.

Des Weiteren zeigt Fig. 4, dass der erste Abschnitt 26 der Bauteilhalteeinheit 16 im Wesentlichen hohlzylindrisch ausgebildet ist.

Ferner ist die Testvorrichtung 10 dazu ausgebildet, dass beim Entfallen des Unterdrucks in der Druckkammer 24, die Bauteilhalteeinheit 16 in eine Entlastungsposition bewegt wird, in der das Bauteil 12 die gehäuseseitigen Kontaktierungsmittel 18 nicht kontaktiert. Zum Bewegen der Bauteilhalteeinheit 16 in die Entlastungsposition wird die Bauteilhalteeinheit 16 entgegen der Bewegungsrichtung A bewegt. Insbesondere sind an dem Gehäuse 14 Federelemente 40 vorgesehen, welche beim Entfallen des Unterdrucks in der Druckkammer 24 die Bauteilhalteeinheit 16 entgegen der Bewegungsrichtung A bewegen, um die Entlastungsposition einzunehmen. Insbesondere können die Federelemente zwischen dem zweiten Abschnitt 26 der Bauteilhalteeinheit 16 und dem Gehäuse 14 angeordnet sein.

Des Weiteren sind an dem Gehäuse 14 Klemmmittel 42 vorgesehen, welche das Bauteil 12 auf die gehäuseseitigen Kontaktierungsmittel 18 drücken. Insbesondere drückt ein Klemmabschnitt 43 des Klemmmittels 42 in einer Klemmposition auf das Bauteil 12, wobei der Klemmabschnitt 43 den gehäuseseitigen Kontaktierungsmitteln 18 gegenüberliegend angeordnet ist. Die Klemmmittel 42 sind ferner über ein Verbindungselement 52 beweglich an dem Gehäuse 14 gelagert. Des Weiteren sind an dem Gehäuse 14 Federelemente 44 vorgesehen, welche das Klemmmittel 42 in die Klemmposition bewegen.

Mit Bezugnahme auf die Fig. 3 und 4 folgt eine nähere Beschreibung des Gehäuses 14. Das Gehäuse 14 weist einen ersten Gehäuseabschnitt 46, einen zweiten Gehäuseabschnitt 48, und eine Leiterplatte 50 auf, welche zwischen dem ersten Gehäuseabschnitt 46 und dem zweiten Gehäuseabschnitt 48 angeordnet ist. Ferner erstreckt sich die Druckkammer 24 bzw. der Hohlraum im Gehäuse 14 durch den ersten Gehäuseabschnitt 46, die Leiterplatte 50 und den zweiten Gehäuseabschnitt 48. Ferner ist vorgesehen, dass der elektrische Anschluss 22 an der Leiterplatte 50 angeordnet ist und die Leiterplatte 50 dazu ausgebildet ist, die gehäuseseitigen Kontaktierungsmittel 18 mit dem elektrischen Anschluss 22 elektrisch zu verbinden.

Des Weiteren sind wie in Fig. 3 gezeigt, die gehäuseseitigen Kontaktierungsmittel 18 als Federkontaktstifte ausgebildet, welche sich entlang der Bewegungsrichtung A durch den ersten Gehäuseabschnitt 46 bis zur Leiterplatte 50 erstrecken.

### Bezugszeichenliste

- 10: Testvorrichtung
- 12: zu testendes Bauteil
- 14: Gehäuse
- 16: Bauteilhalteeinheit
- 18: Kontaktierungsmittel (gehäuseseitig)
- 20: Kontaktierungsmittel (bauteilseitig)
- 22: elektrischer Anschluss
- 24: Druckkammer
- 26: erster Abschnitt der Bauteilhalteeinheit
- 28: zweiter Abschnitt der Bauteilhalteeinheit
- 30: Auflagefläche
- 32: Öffnung
- 34: innerer Bereich der Auflagefläche
- 36: äußerer Bereich der Auflagefläche
- 38: Druckanschluss
- 40: Federelemente (Bauteilhalteeinheit)
- 42: Klemmmittel
- 43: Klemmabschnitt
- 44: Federelemente (Klemmmittel)
- 46: erster Gehäuseabschnitt
- 48: zweiter Gehäuseabschnitt
- 50: Leiterplatte
- 52: Verbindungselement
- A: Bewegungsrichtung

## Patentansprüche

1. Testvorrichtung (10) zum Testen elektrischer Bauteile (12), aufweisend:
- ein Gehäuse (14), wobei das Gehäuse (14) einen zylindrisch ausgebildeten Hohlraum (24) aufweist;
- an dem Gehäuse (14) angeordnete Kontaktierungsmittel (18) zum elektrischen Kontaktieren eines zu testenden Bauteils (12); und
- eine Bauteilhalteeinheit (16), die einen ersten Abschnitt (26) und einen zweiten Abschnitt (28) aufweist, wobei der erste Abschnitt (26) zylindrisch ausgebildet und zumindest teilweise in dem Hohlraum (24) des Gehäuses (14) angeordnet ist, wobei der zweite Abschnitt (28) der Bauteilhalteeinheit (16) zum Auflegen des zu testenden Bauteils (12) ausgebildet ist,
wobei die Bauteilhalteeinheit (16) in Bezug auf das Gehäuse (14) beweglich ausgebildet ist und in Kontakt mit einer in dem Gehäuse (14) angeordneten Druckkammer, die durch den Hohlraum (24) gebildet ist, steht, und
wobei beim Erzeugen eines Unterdrucks in der Druckkammer (24), die Bauteilhalteeinheit (16) in eine Testposition bewegbar ist, bei der das zu testende Bauteil (12) die Kontaktierungsmittel (18) kontaktiert.

2. Testvorrichtung (10) nach Anspruch 1, wobei die Bauteilhalteeinheit (16) dazu ausgebildet ist, das aufgelegte Bauteil (12) mittels des Unterdrucks zu halten.

3. Testvorrichtung (10) nach Anspruch 1 oder 2, wobei der zweite Abschnitt (28) der Bauteilhalteeinheit (16) eine Auflagefläche (30) aufweist, auf die das zu testende Bauteil (12) zumindest teilweise flächig aufgelegt wird.

4. Testvorrichtung (10) nach Anspruch 3, wobei die Auflagefläche (30) eine Öffnung (32) aufweist, die in Verbindung mit der Druckkammer (24) steht.

5. Testvorrichtung (10) nach einem der vorangegangenen Ansprüche, wobei beim Entfallen des Unterdrucks, die Bauteilhalteeinheit (16) in eine Entlastungsposition bewegbar ist, bei der das zu testende Bauteil (12) die Kontaktierungsmittel (18) nicht kontaktiert.

6. Testvorrichtung (10) nach einem der vorangegangenen Ansprüche, ferner aufweisend einen an dem Gehäuse (14) angeordneter Druckanschluss (38) zum Herstellen einer Verbindung zwischen der Druckkammer (24) und einem Druckkontrollmittel; und/oder
ferner aufweisend ein Druckkontrollmittel zum Erzeugen des Unterdrucks in der Druckkammer (24).

7. Testvorrichtung (10) nach einem der vorangegangenen Ansprüche, ferner aufweisend einen elektrischen Anschluss (22) zum Verbinden der Kontaktierungsmittel (18) mit einer Prüfvorrichtung.

8. Testvorrichtung (10) nach einem der vorangegangenen Ansprüche, ferner aufweisend ein Klemmmittel (42), das dazu ausgebildet ist, das zu testende Bauteil (12) auf die Kontaktierungsmittel (18) zu drücken.

9. Testvorrichtung (10) nach Anspruch 8, wobei das Klemmmittel (42) als federgelagertes Klemmmittel ausgebildet ist.

10. Testvorrichtung (10) nach einem der vorangegangenen Ansprüche, wobei die Kontaktierungsmittel (18) als Federkontaktstifte ausgebildet sind.

11. Testvorrichtung (10) nach einem der vorangegangenen Ansprüche, wobei die Bauteilhalteeinheit (16) dazu ausgebildet ist, das aufgelegte Bauteil (12) mittels des Unterdrucks zu halten und wobei keine Sicherungsmittel vorgesehen sind, die das Bauteil an der Bauteilhalteeinheit sichern.

12. Verwendung einer Testvorrichtung (10) nach einem der vorangegangenen Ansprüche zum Testen eines elektrischen Bauteils (12).

13. Verfahren zum Testen eines elektrischen Bauteils (12) mittels einer Testvorrichtung (10) nach einem der Ansprüche 1-11, aufweisend:
- Auflegen eines zu testenden Bauteils (12) auf die Bauteilhalteeinheit (16);
- Erzeugen eines Unterdrucks in der Druckkammer (24); und
- Testen des Bauteils (12).

## Claims

1. Test device (10) for testing electrical components (12), comprising:
- a housing (14), wherein the housing (14) comprises a cylindrical cavity (24);
- contacting means (18) arranged on the housing (14) for electrically contacting a component (12) to be tested; and
- a component-holding unit (16), which comprises a first portion (26) and a second portion (28), wherein the first portion (26) is cylindrical and is arranged in the cavity (24) in the housing (14) at least in part, wherein the second portion (28) of the component-holding unit (16) is configured for placing on the component (12) to be tested,
wherein the component-holding unit (16) is configured to be movable relative to the housing (14) and is in contact with a pressure chamber, which is arranged in the housing (14) and is formed by the cavity (24), and
wherein, when generating a negative pressure in the pressure chamber (24), the component-holding unit (16) is movable into a test position, in which the component (12) to be tested contacts the contacting means (18).

2. Test device (10) according to claim 1, wherein the component-holding unit (16) is configured to hold the placed-on component (12) by means of the negative pressure.

3. Test device (10) according to claim 1 or 2, wherein the second portion (28) of the component-holding unit (16) comprises a support surface (30), onto which the component (12) to be tested is placed in a planar manner at least in part.

4. Test device (10) according to claim 3, wherein the support surface (30) comprises an opening (32), which is in communication with the pressure chamber (24).

5. Test device (10) according to any one of the preceding claims, wherein, when the negative pressure is not applied, the component-holding unit (16) is movable into an unloaded position, in which the component (12) to be tested does not contact the contacting means (18).

6. Test device (10) according to any one of the preceding claims, further comprising a pressure connection (38) arranged on the housing (14) for establishing a connection between the pressure chamber (24) and a pressure-monitoring means; and/or
further comprising a pressure-monitoring means for generating the negative pressure in the pressure chamber (24).

7. Test device (10) according to any one of the preceding claims, further comprising an electrical connection (22) for connecting the contacting means (18) to a check device.

8. Test device (10) according to any one of the preceding claims, further comprising a clamping means (42), which is configured to press the component (12) to be tested onto the contacting means (18).

9. Test device (10) according to claim 8, wherein the clamping means (42) is configured as a spring-mounted clamping means.

10. Test device (10) according to any one of the preceding claims, wherein the clamping means (18) are configured as spring-loaded contact pins.

11. Test device (10) according to any one of the preceding claims, wherein the component-holding unit (16) is configured to hold the placed-on component (12) by means of the negative pressure, and wherein no securing means are provided which secure the component to the component-holding unit.

12. Use of a test device (10) according to any one of the preceding claims for testing an electrical component (12).

13. Method for testing an electrical component (12) by means of a test device (10) according to any one of claims 1-11, comprising:
- placing a component (12) to be tested onto the component-holding unit (16);
- generating a negative pressure in the pressure chamber (24); and
- testing the component (12).

## Revendications

1. Dispositif de test (10) pour tester des composants électriques (12), présentant :
- un boîtier (14), le boîtier (14) présentant une cavité (24) réalisée sous forme cylindrique ;
- des moyens de contact (18) agencés sur le boîtier (14) pour établir un contact électrique avec un composant (12) à tester ; et
- une unité de support de composant (16), qui présente une première section (26) et une deuxième section (28), la première section (26) étant réalisée sous forme cylindrique et agencée au moins partiellement dans la cavité (24) du boîtier (14), la deuxième section (28) de l'unité de support de composant (16) étant réalisée pour poser le composant (12) à tester,
l'unité de support de composant (16) étant réalisée sous forme mobile par rapport au boîtier (14) et étant en contact avec une chambre de pression agencée dans le boîtier (14), qui est formée par la cavité (24), et
lors de la génération d'une dépression dans la chambre de pression (24), l'unité de support de composant (16) pouvant être déplacée vers une position de test dans laquelle le composant (12) à tester entre en contact avec les moyens de contact (18).

2. Dispositif de test (10) selon la revendication 1, dans lequel l'unité de support de composant (16) est réalisée pour maintenir le composant (12) posé au moyen de la dépression.

3. Dispositif de test (10) selon la revendication 1 ou 2, dans lequel la deuxième section (28) de l'unité de support de composant (16) présente une surface de pose (30) sur laquelle le composant (12) à tester est posé au moins partiellement à plat.

4. Dispositif de test (10) selon la revendication 3, dans lequel la surface de pose (30) présente une ouverture (32) qui est en communication avec la chambre de pression (24).

5. Dispositif de test (10) selon l'une quelconque des revendications précédentes, dans lequel, lors de la disparition de la dépression, l'unité de support de composant (16) peut être déplacée vers une position de décharge dans laquelle le composant (12) à tester n'entre pas en contact avec les moyens de contact (18).

6. Dispositif de test (10) selon l'une quelconque des revendications précédentes, présentant en outre un raccord de pression (38) agencé sur le boîtier (14) pour établir une communication entre la chambre de pression (24) et un moyen de contrôle de la pression ; et/ou
présentant en outre un moyen de contrôle de la pression pour générer la dépression dans la chambre de pression (24).

7. Dispositif de test (10) selon l'une quelconque des revendications précédentes, présentant en outre un raccord électrique (22) pour relier les moyens de contact (18) à un dispositif de vérification.

8. Dispositif de test (10) selon l'une quelconque des revendications précédentes, présentant en outre un moyen de serrage (42), qui est réalisé pour presser le composant (12) à tester sur le moyen de contact (18).

9. Dispositif de test (10) selon la revendication 8, dans lequel le moyen de serrage (42) est réalisé sous forme de moyen de serrage monté sur ressort.

10. Dispositif de test (10) selon l'une quelconque des revendications précédentes, dans lequel les moyens de contact (18) sont réalisés sous forme de broches de contact à ressort.

11. Dispositif de test (10) selon l'une quelconque des revendications précédentes, dans lequel l'unité de support de composant (16) est réalisée pour supporter le composant (12) posé au moyen de la dépression, et dans lequel aucun moyen de fixation n'est prévu pour fixer le composant à l'unité de support de composant.

12. Utilisation d'un dispositif de test (10) selon l'une quelconque des revendications précédentes pour tester un composant électrique (12).

13. Procédé de test d'un composant électrique (12) au moyen d'un dispositif de test (10) selon l'une quelconque des revendications 1 à 11, présentant :
- la pose d'un composant (12) à tester sur l'unité de support de composant (16) ;
- la génération d'une pression négative dans la chambre de pression (24) ; et
- le test du composant (12).
